# EUROPEAN PATENT APPLICATION

(11) **EP 4 478 342 A1**
(43) Date of publication of application: **18.12.2024**
(21) Application number: 23787609.9
(22) Date of filing: 07.04.2023
(51) Int. Cl.: G09G 3/30

(54) **DISPLAY MODULE, ELECTRONIC DEVICE, AND PREPARATION METHOD FOR DISPLAY MODULE**

(30) Priority: 15.04.2022 CN 202210397251
(71) Applicant: Huawei Technologies Co., Ltd., Shenzhen, Guangdong 518129 (CN)
(72) Inventor: LONG, Haohui, Shenzhen, Guangdong 518129 (CN); ZHANG, Li, Shenzhen, Guangdong 518129 (CN); SUN, Yizhe, Shenzhen, Guangdong 518129 (CN); MA, Huicai, Shenzhen, Guangdong 518129 (CN)
(74) Representative: Pfenning, Meinig & Partner mbB
(86) International application number: PCT/CN2023/087028
(87) International publication number: WO 2023/197965

(57) **Abstract**

This application provides a display assembly and an electronic device, and relates to the field of display technologies. This application provides a display panel system with system in package. The display assembly includes a flexible display panel and a chip package body. The flexible display panel includes a display area, a bent area located at an outer edge of the display area, and a lower frame area adjacent to the bent area. The chip package body (for example, a display driver integrated circuit) is disposed in the lower frame area. In addition, the display assembly further includes a packaging structure. The packaging structure includes a substrate, and a first electronic component and a second electronic component that are disposed on the substrate. The substrate is disposed in the lower frame area. The lower frame area includes a first routing structure, and the first electronic component and the second electronic component are electrically connected to the chip package body through the first routing structure. The display assembly can reduce space occupied in the electronic device.

## Description

This application claims priority to Chinese Patent Application No. 202210397251.2, filed with the China National Intellectual Property Administration on April 15, 2022 and entitled "DISPLAY ASSEMBLY, ELECTRONIC DEVICE, AND DISPLAY ASSEMBLY PREPARATION METHOD", which is incorporated herein by reference in its entirety.

### TECHNICAL FIELD

This application relates to the field of display technologies, and in particular, to a display assembly, an electronic device including the display assembly, and a display assembly preparation method.

### BACKGROUND

As human-computer interaction technologies develop, display becomes an important element of human-computer interaction. A display driver integrated circuit (display driver integrated circuit, DDIC) and a touch control chip (touch panel integrated circuit, TPIC) are very important components of a display touch imaging system, so that a resistor, a regulator, a power transistor, and other components are integrated for driving a display panel, controlling a drive current, and other functions.

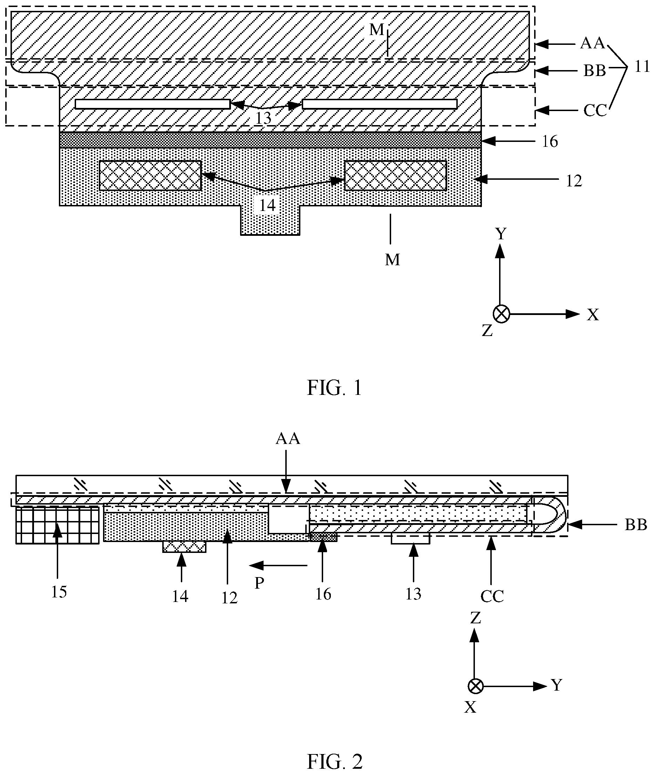

FIG. 1 and FIG. 2 show a packaging structure of a display driver integrated circuit DDIC in a display apparatus (for example, a mobile phone), and FIG. 2 is a sectional view obtained after cutting in an M-M direction in FIG. 1. The packaging structure may be referred to as chip on panel (chip on panel, COP) packaging. Specifically, with reference to both FIG. 1 and FIG. 2, an edge part of a flexible display panel 11 is bent, so that a display area AA, a lower frame area CC, and a bent area BB that connects the display area AA and the lower frame area CC are formed on the flexible display panel 11.

The display driver integrated circuit 13 is disposed in the lower frame area CC, and other electronic components 14, such as a touch chip (TPIC), a capacitor, and a resistor, are integrated on a flexible printed circuit (flexible printed circuit, FPC) board 12 that is electrically connected to a main circuit board. The FPC 12 extends in a direction parallel to the lower frame area CC, and the FPC 12 is connected to the lower frame area CC through a bonding structure 16, to implement signal interconnection between the electronic component 14 on the FPC 12 and the display driver integrated circuit 13.

When the chip packaging technology of the panel shown in FIG. 1 and FIG. 2 is used, because all the electronic components 14 electrically connected to the display driver integrated circuit 13 are integrated on the FPC 12, an FPC 12 that occupies large space needs to be arranged. Therefore, a size of the display device is increased. For example, a size in a Y direction shown in FIG. 2 is large.

In other words, when the size of the display apparatus in the Y direction is fixed, because of existence of the large-size FPC 12, a size of another structure in the Y direction is correspondingly decreased. For example, as shown in FIG. 2, use space of a battery 15 in the Y direction is limited. As a result, an increase of a battery capacity may be limited, and an increase of a battery life of the display apparatus like a mobile phone is limited.

### SUMMARY

This application provides a display assembly, an electronic device including the display assembly, and a display assembly preparation method. A solution of this application provides the display assembly that can reduce occupied space, so that when the display assembly is used in the electronic device, more placement space can be reserved for another mechanical part in the electronic device.

To achieve the foregoing objective, this application uses the following technical solutions.

According to a first aspect, this application provides a display assembly. The display assembly may be used in an electronic device having a display function, for example, a mobile phone or a television.

The display assembly includes a flexible display panel and a chip package body. The flexible display panel includes a display area, a bent area located at an outer edge of the display area, and a lower frame area adjacent to the bent area. The lower frame area is located on the back of the display area. The chip package body (for example, a display driver integrated circuit) is disposed in the lower frame area. In addition, the display assembly further includes a packaging structure. The packaging structure includes a substrate, and a first electronic component and a second electronic component that are disposed on the substrate, and the substrate is disposed in the lower frame area. In addition, the lower frame area includes a first routing structure, and the first electronic component and the second electronic component are electrically connected to the chip package body through the first routing structure.

In the display assembly provided in this application, for example, the display driver integrated circuit may be disposed in the lower frame area. In this case, the display driver integrated circuit may drive a driver circuit of a pixel unit in the display area, to implement a display function. In addition, the first electronic component and the second electronic component that are electrically connected to the display area are further provided. For example, the first electronic component and the second electronic component may be capacitors, inductors, resistors, touch chips, or the like. The first electronic component and the second electronic component are packaged in the packaging structure by using a system in package (system in package, SIP) technology, and the packaging structure is also disposed in the lower frame area. In this way, when the display assembly has a circuit board electrically connected to a main circuit board, because some electronic components (for example, the first electronic component and the second electronic component herein) electrically connected to the display area or all electronic components may be transferred from the circuit board to the packaging structure, a size of the circuit board may be reduced, and space occupied by the circuit board may be reduced, to reduce space occupied by the display assembly.

Therefore, when the display assembly provided in this application is used in the electronic device, larger accommodation space may be reserved for another mechanical part, or when a size of the another mechanical part remains unchanged, the electronic device can meet a miniaturization design requirement.

In a possible implementation, the display assembly further includes a circuit board. The circuit board may be a flexible printed circuit board. An extension direction of the circuit board is perpendicular to an extension direction of the lower frame area, and the circuit board is configured to electrically connect the lower frame area and the main circuit board.

In this embodiment, a manner of disposing the circuit board is as follows: The extension direction of the circuit board is perpendicular to the extension direction of the lower frame area, instead of being parallel to the extension direction of the lower frame area in the conventional technology. For example, when the lower frame area extends in a Y direction of the electronic device, the circuit board extends in an X direction perpendicular to the Y direction. In this way, space occupied in the Y direction is reduced.

In addition, because some or all electronic components on the circuit board are packaged in the packaging structure, the circuit board with a smaller size does not occupy large space in the X direction.

In a possible implementation, a first part of the circuit board is located on a side of the lower frame area, and the first part is configured to electrically connect to the main circuit board.

In a possible implementation, the display assembly further includes a third electronic component. The third electronic component is disposed on the first part, and the third electronic component is electrically connected to the display area, or is electrically connected to the first electronic component and the second electronic component.

When a part of electronic components, for example, the third electronic component including a resistor, is not integrated into the packaging structure, the third electronic component may be integrated into the first part, and is electrically connected to the display area, or to the first electronic component and the second electronic component.

In a possible implementation, a second part of the circuit board covers the lower frame area, and the second part is electrically connected to the lower frame area. An accommodating cavity is provided on the second part, and both the chip package body and the packaging structure are disposed in the accommodating cavity.

In this implementation, compared with integrating all electronic components into the circuit board, integrating a part of electronic components into the packaging structure can reduce a quantity of conductive layers of the circuit board, to reduce a thickness size of the second part. In this way, a size of the display assembly in a direction perpendicular to the lower frame area is not excessively increased. For example, a size of the display assembly in a Z direction perpendicular to both the X direction and the Y direction is not excessively increased.

In a possible implementation, an end that is of the second part and that is far away from the first part is electrically connected to the lower frame area through a connection structure, for example, through a bonding structure.

In this embodiment of this application, on the basis of changing a position of the circuit board, a connection process between the circuit board and the lower frame area may further remain unchanged, that is, be compatible with an existing connection process.

In a possible implementation, the first electronic component or the second electronic component includes at least one of a touch chip and a passive component. For example, the first electronic component is a touch chip, and the second electronic component includes an inductor, a resistor, and the like.

In a possible implementation, the lower frame area includes a base, and a first routing structure is formed on the base. The first routing structure includes at least three first conductive layers, a first dielectric layer, and a first conductive channel. The at least three first conductive layers are stacked in a direction perpendicular to the base; the first dielectric layer is disposed between every two adjacent first conductive layers for isolation; and the first conductive channel passes through the first dielectric layer, to electrically connect different first conductive layers.

The routing structure configured to electrically connect the packaging structure and the display area is a multi-layer (at least three layers) routing structure, instead of a single-layer or two-layer routing structure in the conventional technology.

In a possible implementation, a second routing structure is further formed in the lower frame area, and the chip package body is electrically connected to the display area through the second routing structure. That is, signal interconnection between the chip package body (for example, the display driver integrated circuit) and the display area may be implemented by using the second routing structure formed on the lower frame area.

In a possible implementation, the second routing structure includes one second conductive layer; or the second routing structure includes two second conductive layers, one second dielectric layer, and one second conductive channel. The two second conductive layers are stacked in a direction perpendicular to the base; one second dielectric layer is disposed between the two second conductive layers; and the second conductive channel passes through the second dielectric layer to electrically connect the two second conductive layers.

In the lower frame area, at least two routing structures of different structures are formed. One is single-layer or double-layer routing, and the other is at least three-layer routing.

In a possible implementation, the second routing structure is arranged closer to the bent area than the first routing structure.

A multi-layer routing structure is far away from the bent area, and a single-layer or double-layer routing structure is close to the bent area.

In a possible implementation, a routing structure with a single conductive layer or two conductive layers is formed on the bent area.

Flexibility of the bent area can be ensured by disposing the routing structure with a single conductive layer or two conductive layers, so that the lower frame area can be located on the back of the display area when the bent area is bent.

In a possible implementation, an arrangement direction of the chip package body and the packaging structure is perpendicular to the extension direction of the lower frame area; or an arrangement direction of the chip package body and the packaging structure is parallel to the extension direction of the lower frame area.

The foregoing provides only two layout manners of the chip package body, for example, the display driver integrated circuit and the packaging structure, and another layout manner may also be used.

In a possible implementation, the chip package body includes a first display driver integrated circuit and a second display driver integrated circuit, an arrangement direction of the first display driver integrated circuit and the second display driver integrated circuit is perpendicular to the extension direction of the lower frame area, and the packaging structure is located between the first display driver integrated circuit and the second display driver integrated circuit.

When the chip package body includes the first display driver integrated circuit and the second display driver integrated circuit, the display assembly of this structure may be used in a foldable display apparatus, for example, a foldable mobile phone.

The packaging structure is disposed between the first display driver integrated circuit and the second display driver integrated circuit, so that a size of the display assembly in a direction consistent with the extension direction of the lower frame area is not increased because the packaging structure is added. For example, a size of the mobile phone in the Y direction is not increased.

In a possible implementation, the chip package body and the packaging structure are located on a side surface that is of the lower frame area and that is away from the display area.

In a possible implementation, the chip package body and the packaging structure are oppositely disposed on two sides of the lower frame area.

In a possible implementation, the first electronic component and the second electronic component are separately disposed on a same surface of the substrate through an electrical connection structure.

The first electronic component and the second electronic component are disposed on the substrate in a two-dimensional integration manner.

In a possible implementation, the first electronic component and the second electronic component are stacked on the substrate in a direction perpendicular to the substrate.

The first electronic component and the second electronic component are disposed on the substrate in a three-dimensional integration manner.

According to a second aspect, this application further provides an electronic device. The electronic device may be an electronic device having a display function.

The electronic device includes a main circuit board and the display assembly in any one of the foregoing implementations. The display assembly is electrically connected to the main circuit board. For example, at least one of a display panel, a display driver circuit, and a packaging structure in the display assembly is electrically connected to the main circuit board.

In the electronic device, the foregoing display assembly is used. In addition, in the display assembly, a display driver integrated circuit may be integrated into a lower frame area of a flexible display panel, and a modular system in package structure that integrated with a first electronic component and a second electronic component that are electrically connected to a display area is also integrated into the lower frame area. Therefore, a circuit board with a large size does not need to be disposed, so that space occupied by the display assembly in the electronic device is reduced.

In a possible implementation, placement space is formed on a side that is of the lower frame area and that is far away from the bent area. The electronic device further includes a battery, and the battery is disposed in the placement space.

Because some electronic components or all electronic components are integrated into the packaging structure, the battery can be placed in larger space, a capacity of the battery can be increased, and a battery life of the electronic device can be increased.

According to a third aspect, this application further provides a display assembly preparation method. The display assembly includes:
disposing, on a lower frame area of a flexible display panel, a chip package body electrically connected to a display area; and
disposing a packaging structure on the lower frame area, where the packaging structure includes a substrate disposed in the lower frame area, and a first electronic component and a second electronic component disposed on the substrate, and the first electronic component and the second electronic component are electrically connected to the chip package body through a first routing structure formed on the lower frame area. The flexible display panel includes the display area, a bent area located at an outer edge of the display area, and the lower frame area adjacent to the bent area. The lower frame area is located on the back of the display area.

In the display assembly preparation method provided above, not only the display driver integrated circuit may be integrated into the lower frame area of the flexible display panel, but also the packaging structure integrated with a plurality of electronic components may be integrated into the lower frame area, that is, the lower frame area is used as a carrier of the plurality of electronic components. In this way, a size of a circuit board can be reduced, so that a size of the prepared display assembly is small, and space occupied by the display assembly is reduced.

In a possible implementation, before the packaging structure and the chip package body are disposed in the lower frame area, the preparation method further includes:
removing a conductive layer and a dielectric layer that are in the lower frame area and that are configured to form a second routing structure, so that the formed second routing structure that is electrically connected to the chip package body and the display area is a single conductive layer or two conductive layers, and retaining a quantity of conductive layers and dielectric layers that are in the lower frame area and that are configured to form the first routing structure to be the same as a quantity of conductive layers and dielectric layers in the display area.

In the preparation method, the conductive layer and the dielectric layer in a part of the lower frame area may be removed, to form single-layer routing or double-layer routing used to electrically connect the display driver integrated circuit and the display area. Other areas may not be processed. In this way, the preparation process can be simplified.

In a possible implementation, after the packaging structure and the chip package body are disposed in the lower frame area, the preparation method further includes:
disposing a circuit board, where the circuit board extends in a direction perpendicular to an extension direction of the lower frame area.

When the circuit board is disposed, the circuit board extends in the direction perpendicular to the extension direction of the lower frame area, instead of being disposed in a direction parallel to the extension direction of the lower frame area.

In a possible implementation, before the circuit board is disposed, the preparation method further includes:
disposing a third electronic component on a part that is of the circuit board and that is located on a side of the lower frame area, so that the third electronic component is electrically connected to the display area, or the third electronic component is electrically connected to the packaging structure.

### BRIEF DESCRIPTION OF DRAWINGS

FIG. 1 is a diagram of a packaging structure of a display driver integrated circuit in the conventional technology;
FIG. 2 is a sectional view obtained after cutting in an M-M direction in FIG. 1;
FIG. 3a is a diagram of a structure of an electronic device according to an embodiment of this application;
FIG. 3b is a diagram of a structure of another electronic device according to an embodiment of this application;
FIG. 4 is a diagram of a structure of disposing a display driver integrated circuit and some electronic components;
FIG. 5a is a diagram of a structure of a display area of a flexible display panel according to an embodiment of this application;
FIG. 5b is a diagram of a structure of a bent area or a lower frame area of a flexible display panel according to an embodiment of this application;
FIG. 6 is a block diagram of a structure of a part of a circuit in an electronic device according to an embodiment of this application;
FIG. 7 is a diagram of a structure of disposing a display driver integrated circuit and some electronic components according to an embodiment of this application;
FIG. 8 is a sectional view obtained after cutting in an N1-N1 direction in FIG. 7;
FIG. 9 is a diagram of a structure of a packaging structure according to an embodiment of this application;
FIG. 10a is a diagram of a structure of disposing a display driver integrated circuit and some electronic components in the conventional technology;
FIG. 10b is a diagram of a structure of disposing a display driver integrated circuit and some electronic components according to an embodiment of this application;
FIG. 11 is a diagram of another structure of disposing a display driver integrated circuit and some electronic components according to an embodiment of this application;
FIG. 12a is a diagram of a structure of disposing a display driver integrated circuit and a packaging structure according to an embodiment of this application;
FIG. 12b is a diagram of another structure of disposing a display driver integrated circuit and a packaging structure according to an embodiment of this application;
FIG. 12c is a diagram of another structure of disposing a display driver integrated circuit and a packaging structure according to an embodiment of this application;
FIG. 12d is a diagram of a structure of disposing a display driver integrated circuit and a packaging structure according to an embodiment of this application;
FIG. 13a is a diagram of a structure of a packaging structure according to an embodiment of this application;
FIG. 13b is a diagram of another structure of a packaging structure according to an embodiment of this application;
FIG. 14a is a diagram of a structure of a substrate of a packaging structure according to an embodiment of this application;
FIG. 14b is a diagram of another structure of a substrate of a packaging structure according to an embodiment of this application;
FIG. 14c is a diagram of another structure of a substrate of a packaging structure according to an embodiment of this application;
FIG. 15 is a diagram of a structure of disposing a display driver integrated circuit, a packaging structure, and a circuit board according to an embodiment of this application;
FIG. 16 is a diagram of another structure of disposing a display driver integrated circuit, a packaging structure, and a circuit board according to an embodiment of this application;
FIG. 17 is a diagram of another structure of disposing a display driver integrated circuit, a packaging structure, and a circuit board according to an embodiment of this application;
FIG. 18 is a sectional view obtained after cutting in an N2-N2 direction in FIG. 17;
FIG. 19 is a diagram of another structure of disposing a display driver integrated circuit, a packaging structure, and a circuit board according to an embodiment of this application;
FIG. 20a is a diagram of a structure of disposing a display driver integrated circuit and a circuit board in the conventional technology;
FIG. 20b is a diagram of another structure of disposing a display driver integrated circuit, a packaging structure, and a circuit board according to an embodiment of this application;
FIG. 21 is a diagram of a structure of disposing a display driver integrated circuit, a packaging structure, and a routing structure according to an embodiment of this application;
FIG. 22 is a sectional view obtained after cutting in an N3-N3 direction in FIG. 21;
FIG. 23 is a diagram of another structure of disposing a display driver integrated circuit, a packaging structure, and a routing structure according to an embodiment of this application;
FIG. 24 is a diagram of another structure of disposing a display driver integrated circuit, a packaging structure, and a routing structure according to an embodiment of this application;
FIG. 25 is a diagram of another structure of disposing a display driver integrated circuit, a packaging structure, and a routing structure according to an embodiment of this application;
FIG. 26 is a diagram of another structure of disposing a display driver integrated circuit, a packaging structure, and a routing structure according to an embodiment of this application;
FIG. 27a to FIG. 27c are corresponding diagrams of a structure obtained after steps in a preparation method of a packaging structure are completed according to an embodiment of this application; and
FIG. 28a to FIG. 28d are corresponding diagrams of a structure obtained after steps in a display assembly preparation method are completed according to an embodiment of this application.

Reference numerals:
100a-first housing;
100b-second housing;
100c-hinge mechanism;
100d-housing;
11- flexible display panel; 11a-base; 11b-light-emitting element; 11c-light-emitting driver circuit; 11d-routing structure;
12- flexible printed circuit board;
13-display driver integrated circuit; 131-first display driver integrated circuit; 132-second display driver integrated circuit;
14-electronic component;
15- battery;
16-bonding structure;
17-circuit board; 17a-first part; 17b-second part; 17b1-accommodating cavity;
18-packaging structure; 18a-substrate; 18b 1-first electronic component; 18b2-second electronic component; 18b3-third electronic component; 18c-packaging layer; 18d-electrical connection structure;
181-first packaging structure; 182-second packaging structure;
19-cover;
20-support layer;
21a-packaging substrate;
21b-redistribution structure;
21c-interposer;
311-base;
312-metal wire;
313-dielectric layer;
314-conductive channel;
41-conductive layer;
42-dielectric layer; and
43-conductive channel.

### DESCRIPTION OF EMBODIMENTS

The following describes in detail specific embodiments of this application with reference to the accompanying drawings.

An embodiment of this application provides an electronic device. The electronic device may include electronic products having a display function such as a mobile phone (mobile phone), a tablet computer (pad), a television, an intelligent wearable product (for example, a smartwatch or a smart band), a virtual reality (virtual reality, VR) terminal device, and an augmented reality (augmented reality AR) terminal device. A specific form of the electronic device having the display function is not specifically limited in embodiments of this application.

For ease of description, the following describes a structure of the electronic device by using the mobile phone as an example.

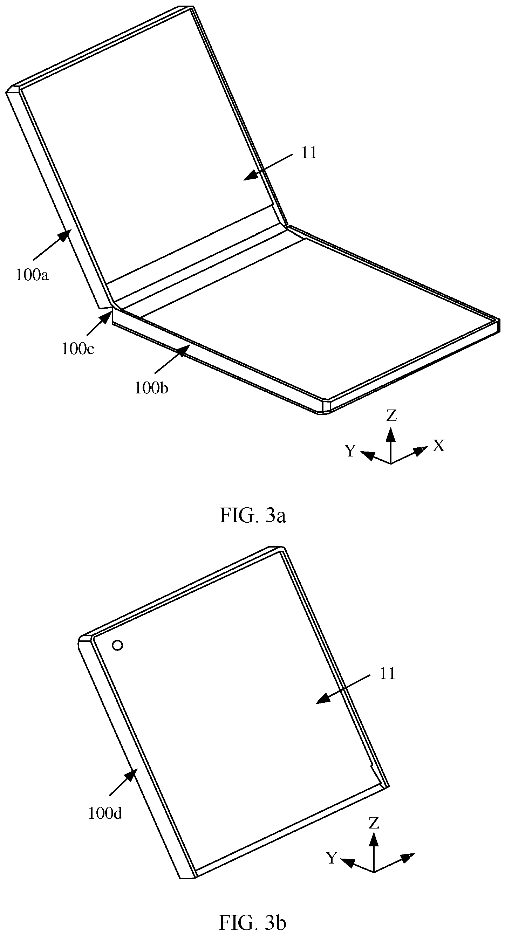

FIG. 3a is a diagram of a structure of a foldable mobile phone. The foldable mobile phone may include a first housing 100a, a second housing 100b, and a flexible display panel 11. The flexible display panel 11 continuously covers the first housing 100a and the second housing 100b. In addition, the foldable mobile phone may further include a hinge mechanism 100c. The first housing 100a and the second housing 100b are disposed on two sides of the hinge mechanism 100c and are separately connected to the hinge mechanism 100c. The hinge mechanism 100c can move, so that the first housing 100a and the second housing 100b are folded or unfolded relative to each other, to implement flattening and closing of the flexible display panel 11.

FIG. 3b is a diagram of a structure of a bar-type mobile phone. The bar-type mobile phone may include a housing 100d and a flexible display panel 11, and the flexible display panel 11 covers the housing 100d.

In the foregoing electronic device like a mobile phone, the flexible display panel 11 can be configured to display information and provide an interaction interface for a user. In embodiments of this application, the flexible display panel 11 may be but is not limited to an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, a quantum dot light-emitting diode (quantum dot light-emitting diode, QLED) display, or the like.

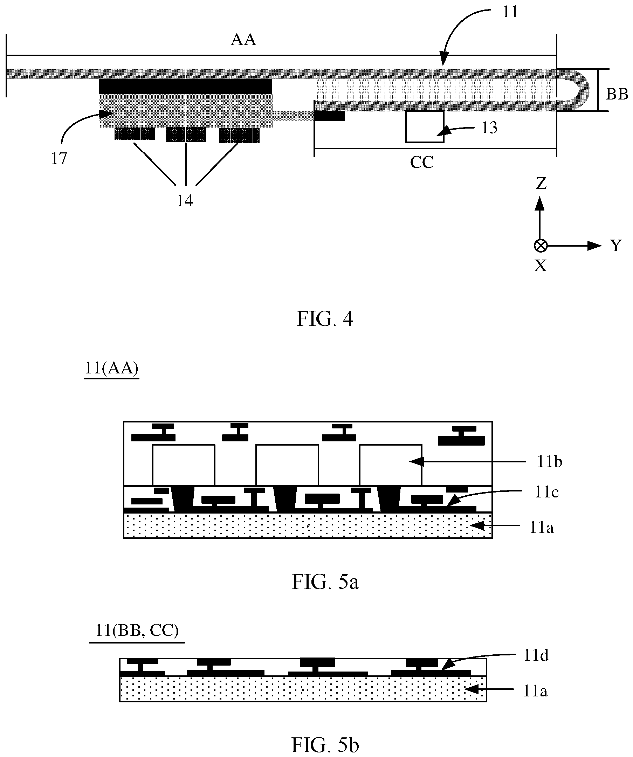

FIG. 4 is a diagram of a structure of the flexible display panel 11 that can be used in the foregoing electronic device. The flexible display panel 11 includes a display area AA used for display for a user, a bent area BB located at an edge of the display area AA, and a lower frame area CC adjacent to the bent area. The bent area BB is used for bending the lower frame area CC to the back of the display area AA. An area in which the bent area BB and the lower frame area CC are connected together may be referred to as a fanout (fanout) area.

A surface that is of the display area AA and that faces the user is the front of the display area AA. On the contrary, a surface opposite to the front of the display area AA is the back of the display area AA. In this case, it is easy to understand a location relationship between the lower frame area CC and the display area AA, to be specific, the lower frame area CC faces the back of the display area AA.

With reference to FIG. 3a, FIG. 3b, and FIG. 4, the bent area BB provided in this application as an example is formed after the lower frame area CC is bent and extends in a Y direction of the electronic device. The Y direction is generally a long-side direction of the electronic device, and an X direction is a short-side direction of the electronic device. FIG. 4 shows only an example structure. In some other embodiments, the bent area BB is formed after the lower frame area CC is bent and extends in the X direction of the electronic device.

Because the display area AA is a surface facing the user, the display area AA includes a light-emitting element. For example, FIG. 5a shows an example of an implementable structure of the display area AA. Specifically, the display area AA may include a base 11a and a light-emitting driver circuit 11c that is disposed on the base 11a and that mainly includes a thin film transistor (thin film transistor, TFT). The light-emitting driver circuit 11c is configured to drive a light-emitting element 11b to emit light. The light-emitting driver circuit 11c and the light-emitting element 1 1b may form a pixel unit. As shown in FIG. 5a, because the display area AA includes the light-emitting driver circuit 11c, a routing structure of the display area AA may include a plurality of conductive layers, for example, include at least three conductive layers, to form a circuit structure.

In addition, FIG. 5b shows an example of an implementable structure of the bent area BB. Because the bent area BB needs specific flexibility, that is, hardness cannot be too high, as shown in FIG. 5b, the bent area BB includes the base 11a and a routing structure 11d disposed on the base 11a. The routing structure 11d is configured to electrically connect the display area AA and another electronic component, and the routing structure 11d has a small quantity of conductive layer structures. Signal interconnection may be performed between the display area AA and the another electronic component by using the routing structure 11d with a small quantity of conductive layer structures. For example, signal interconnection may be performed between the light-emitting driver circuit 11c and a main circuit board by using the routing structure 11d. From a perspective of convenience of process manufacturing, the lower frame area CC may also use the structure shown in FIG. 5b.

Further, in the electronic device like the foregoing electronic device, in a housing configured to support the flexible display panel 11, for example, in the first housing 100a and/or the second housing 100b of the foldable mobile phone in FIG. 3a, or in the housing 100d of the bar-type mobile phone in FIG. 3b, installation space may be formed to install electronic components such as a main circuit board, a battery, a receiver, a speaker, and a camera of the electronic device. The main circuit board may integrate electronic components such as a primary controller, a storage unit, an antenna module, and a power management module of the electronic device. The battery may supply power to electronic components such as the flexible display panel 11, the main circuit board, the receiver, the speaker, and the camera.

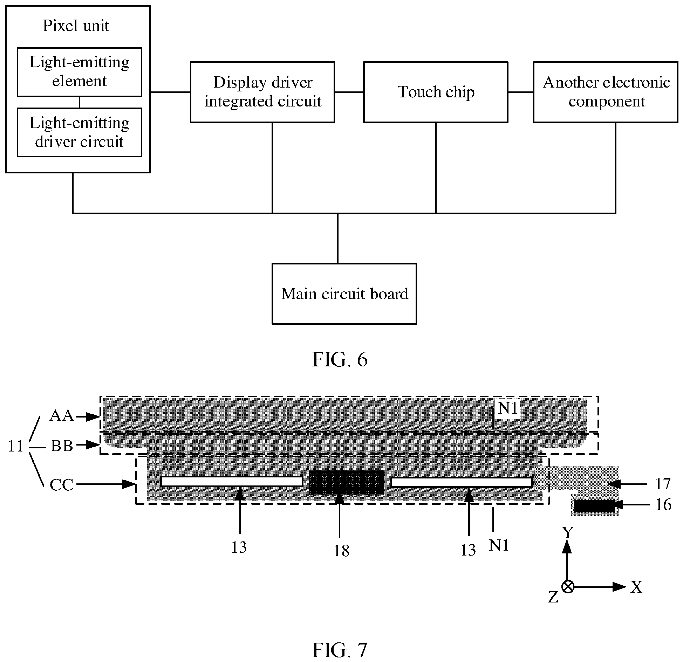

FIG. 6 is a block diagram of an example of a partial circuit structure in an electronic device. The circuit structure of the electronic device may include a main circuit board, a display driver integrated circuit, a touch chip, a pixel unit, and another electronic component related to the display driver integrated circuit and the touch chip. For example, the another electronic component may be a passive component, for example, an inductor, a capacitor, or a resistor.

The display driver integrated circuit and the touch chip are important components of a display touch imaging system, so that components such as a resistor, a regulator, and a power transistor are integrated for functions such as driving a flexible display panel and controlling a drive current. The pixel unit, the display driver integrated circuit, the touch chip, and the another electronic component are all electrically connected to the main circuit board.

Refer to FIG. 4 and FIG. 6. A display driver integrated circuit 13 in FIG. 6 may be integrated into the lower frame area CC in FIG. 4, and a related electronic component electrically connected to the display driver integrated circuit 13 may be integrated on a circuit board 17. For example, an electronic component 14 in FIG. 4 may include the touch chip, the another electronic component, and the like in FIG. 6. In this way, the circuit board 17 not only has a function of electrically connecting to the main circuit board, but also needs to have a large size to carry electronic components electrically connected to the display driver integrated circuit 13 or the display area. As a result, the size of the circuit board 17 is large. In such a design, as shown in FIG. 3a and FIG. 3b, a size of the mobile phone in the Y direction is large.

Based on the foregoing descriptions, an embodiment of this application provides a display assembly that can be used in the foregoing electronic device. The display assembly improves a packaging technology of an electronic component, so that when the display assembly is used in the electronic device, the display assembly does not occupy large space. A specific structure is described below.

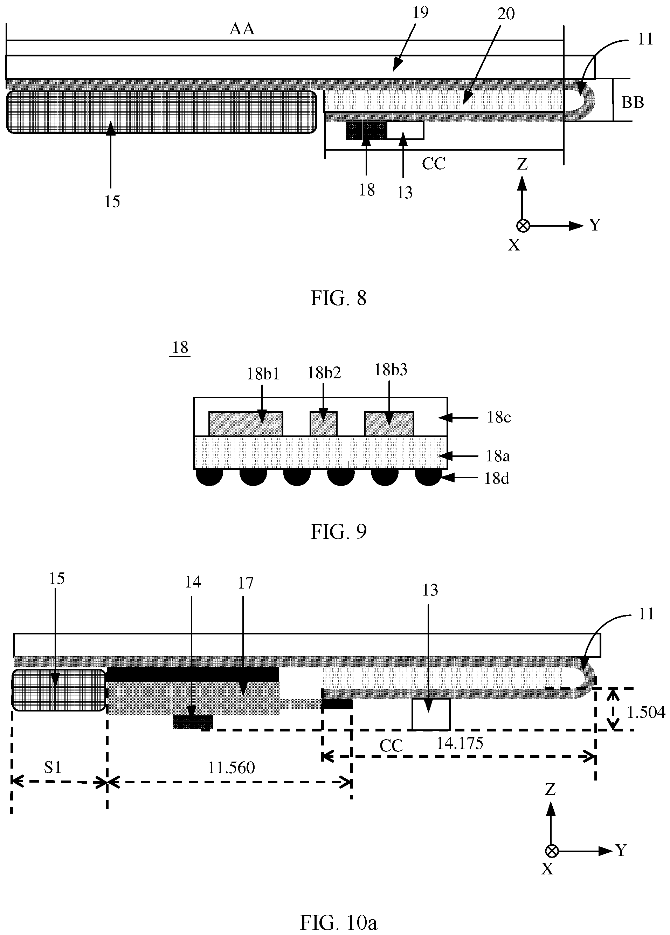

FIG. 7 is a diagram of a connection relationship between the flexible display panel 11 and some electronic components carried on the flexible display panel 11 according to an embodiment of this application. FIG. 7 shows a part of a display area AA, a lower frame area CC, and a bent area BB connecting the display area AA and the lower frame area CC. FIG. 8 is a sectional view obtained after cutting in an N1-N1 direction in FIG. 7.

With reference to FIG. 7 and FIG. 8, similar to the foregoing embodiment, the flexible display panel 11 on which the display area AA, the bent area BB, and the lower frame area CC are formed is also included, a chip package body (for example, the display driver integrated circuit 13 electrically connected to the display area AA) is disposed in the lower frame area CC, and a transparent cover 19 of the electronic device covers the display area AA, to serve as a display window. In addition, a support layer 20 is further disposed between the lower frame area CC and the display area AA, and the support layer 20 is used to support and protect the display area AA and the lower frame area CC. In an implementable structure, a bonding adhesive layer may be used as a structure of the support layer 20.

A difference between the structure shown in FIG. 7 and FIG. 8 and the structure in the foregoing embodiment lies in that a packaging structure 18 is further disposed in the lower frame area CC provided in this embodiment of this application, and the packaging structure 18 includes some electronic components electrically connected to the display driver integrated circuit 13 and/or the display area AA.

The chip package body in embodiments of this application may be the display driver integrated circuit 13, or may be another chip package structure electrically connected to the display area. It may also be understood that the display driver integrated circuit 13 may alternatively be another chip package structure electrically connected to the display area.

FIG. 9 is a diagram of a structure of the packaging structure 18. The packaging structure 18 may include a substrate 18a and a plurality of electronic components disposed on the substrate 18a. For example, FIG. 9 shows an example of the structure including a first electronic component 18b1, a second electronic component 18b2, and a third electronic component 18b3. In some other structures, the first electronic component 18b1 and the second electronic component 18b2 may be included, or more electronic components may be included.

The substrate 18a is disposed in the lower frame area CC by using an electrical connection structure 18d. The electrical connection structure 18d may include a plurality of solder balls, for example, a ball grid array (ball grid array, BGA), or include a plurality of metal columns.

In addition, the packaging structure 18 may further include a packaging layer 18c, and the electronic components integrated on the substrate 18a may be wrapped in the packaging layer 18c, to implement galvanic isolation between these electronic components. In addition, the packaging structure 18 may further include a heat dissipating lid, and the heat dissipating lid covers the packaging layer 18c, to dissipate heat diffused by these electronic components.

The electronic component in the foregoing packaging structure 18 may include some peripheral components related to the display driver integrated circuit 13, for example, a resistor and a capacitor, or the electronic component may include a touch chip electrically connected to the display area, or the electronic component may include some peripheral components related to a touch chip, for example, a resistor and a capacitor.

Still refer to the packaging structures shown in FIG. 7, FIG. 8, and FIG. 9. In this embodiment of this application, some electronic components electrically connected to the display area and/or the display driver integrated circuit 13 are transferred from being disposed on the circuit board 17 shown in FIG. 4 to being integrated into the lower frame area CC, and exist in a system in package (system in package, SIP) form. In addition, a routing structure formed on the flexible display panel 11 may be used to electrically connect the packaging structure 18 and the display area AA or the display driver integrated circuit 13. A size of the circuit board 17 may be reduced because position setting of the electronic component is adjusted. The circuit board 17 mainly functions to electrically connect the flexible display panel 11 and the main circuit board, and weakens a function of bearing these electronic components. For example, the circuit board 17 may be reduced from a large size shown in FIG. 4 to a small size shown in FIG. 7.

When the size of the circuit board 17 is reduced, more accommodation space can be reserved for another structure in the electronic device, for example, accommodation space of a battery can be increased. With reference to the accompanying drawings, the following describes in detail how to reserve more space for another mechanical part when embodiments of this application are used.

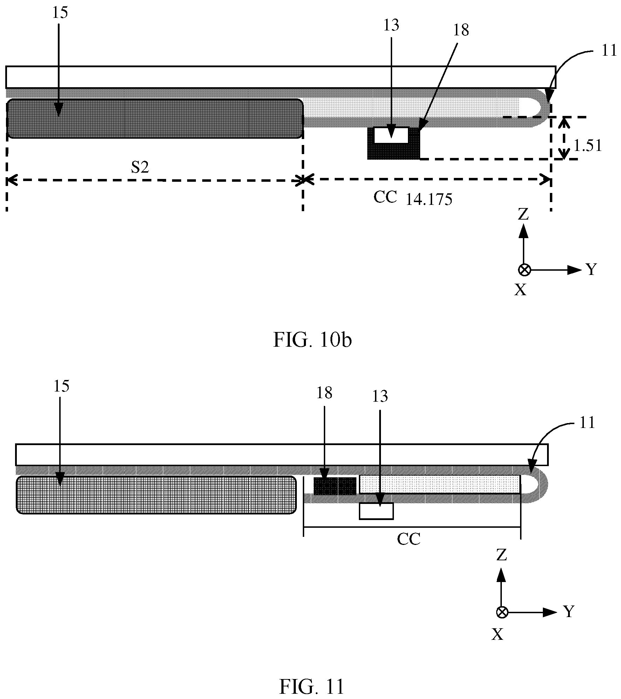

As shown in FIG. 10a and FIG. 10b, FIG. 10a is a diagram of a structure of a display assembly in which a plurality of electronic components are integrated on the circuit board 17 in the conventional technology, and FIG. 10b is a diagram of a structure of a display assembly including the packaging structure 18 disposed on the flexible display panel 11 in an embodiment of this application. A size of the lower frame area CC of the flexible display panel 11 in a Y direction is 14.175 mm. Compared with FIG. 10a and FIG. 10b, in FIG. 10a, a size of the circuit board 17 in the Y direction is 11.560 mm, and a size reserved for a battery 15 is S1. However, as shown in FIG. 10b, after the electronic component is integrated into the packaging structure 18 by using a packaging technology, a size reserved for the battery 15 is increased from S1 in FIG. 10a to S2. Therefore, in this application, a capacity of the battery 15 can be increased, and a battery life of the electronic device can be increased. This improves use performance of the electronic device.

Still refer to FIG. 10a and FIG. 10b. Because the plurality of electronic components in FIG. 10a are integrated into the packaging structure 18 in FIG. 10b, in FIG. 10a, in a direction Z perpendicular to the Y direction, a surface that is of the electronic component 14 and that is far away from the circuit board 17 and a surface that is of the display driver integrated circuit 13 and that is far away from the lower frame area CC are 1.504 mm away from a surface of the lower frame area CC, and in this embodiment of this application, a surface that is of the packaging structure 18 and that is far away from the bonding area CC is 1.51 mm away from the surface of the lower frame area CC. An increase from 1.504 mm to 1.51 mm is small. Therefore, when the display assembly including the packaging structure 18 in this application is used, a size in the Z direction is basically not increased.

There are a plurality of cases in which the packaging structure 18 is disposed in the lower frame area CC. The following provides several implementations.

As shown in FIG. 8 and FIG. 10b, the packaging structure 18 is disposed on a surface that is of the lower frame area CC and that is away from the display area AA, that is, both the packaging structure 18 and the display driver integrated circuit 13 may be integrated on the surface that is of the lower frame area CC and that is away from the display area AA.

In some other implementations, as shown in FIG. 11, FIG. 11 is a diagram of still another structure of a display assembly according to an embodiment of this application. Specifically, the packaging structure 18 may be disposed on a surface that is of the lower frame area CC and that faces the display area AA, and the display driver integrated circuit 13 is disposed on a surface that is of the lower frame area CC and that is away from the display area AA. That is, the packaging structure 18 and the display driver integrated circuit 13 are disposed on two opposite sides of the lower frame area CC.

In still some implementations, the packaging structure 18 may be disposed on the surface that is of the lower frame area CC and that is away from the display area AA, and the display driver integrated circuit 13 is disposed on the surface that is of the lower frame area CC and that faces the display area AA.

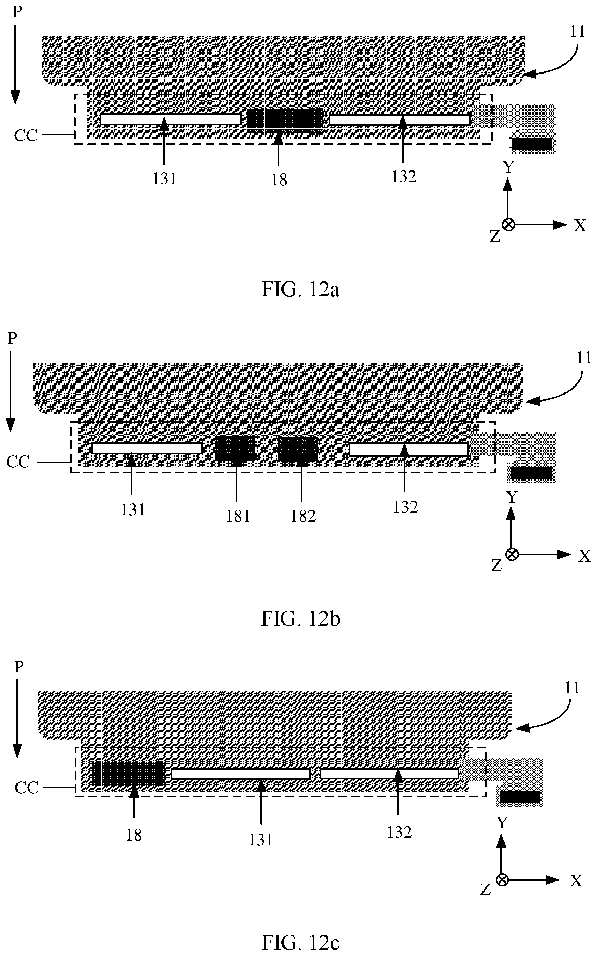

A quantity of packaging structures 18 is not specially limited in this embodiment of this application either. For example, one packaging structure may be included as shown in FIG. 12a; for another example, a first packaging structure 181 and a second packaging structure 182 may be included as shown in FIG. 12b; or more packaging structures may be included.

There are a plurality of implementations for relative positions of the packaging structure 18 and the display driver integrated circuit 13. For details, refer to the following.

FIG. 12a shows a manner of setting relative positions of the packaging structure 18 and the display driver integrated circuit 13. The packaging structure 18 and the display driver integrated circuit are arranged in a direction perpendicular to an extension direction (for example, a P direction in the figure) of the lower frame area CC.

FIG. 12b shows another manner of setting relative positions of the packaging structure 18 and the display driver integrated circuit 13. In this implementation, the packaging structure 18 and the display driver integrated circuit are also arranged in the direction perpendicular to an extension direction (for example, a P direction in the figure) of the lower frame area CC.

Similar to FIG. 12b and FIG. 12a, the display driver integrated circuit includes a first display driver integrated circuit 131 and a second display driver integrated circuit 132. For example, in a folded electronic device (for example, the foldable mobile phone in FIG. 3a), the first display driver integrated circuit 131 may drive the flexible display panel 11 on the first housing 100a, and the second display driver integrated circuit 132 may drive the flexible display panel 11 on the second housing 100b.

A difference between FIG. 12b and FIG. 12a lies in that, in FIG. 12a, there is one packaging structure 18, the packaging structure 18, the first display driver integrated circuit 131, and the second display driver integrated circuit 132 are arranged in a direction perpendicular to a P direction, and the packaging structure 18 is disposed between the first display driver integrated circuit 131 and the second display driver integrated circuit 132; and in FIG. 12b, a first packaging structure 181, a second packaging structure 182, the first display driver integrated circuit 131, and the second display driver integrated circuit 132 are arranged in a direction perpendicular to a P direction, and the first packaging structure 181 and the second packaging structure 182 are located between the first display driver integrated circuit 131 and the second display driver integrated circuit 132.

FIG. 12c shows another manner of setting relative positions of the packaging structure 18 and the display driver integrated circuit 13. Similar to FIG. 12a, the packaging structure 18, the first display driver integrated circuit 131, and the second display driver integrated circuit 132 are arranged in the direction perpendicular to the P direction. A difference lies in that the packaging structure 18 is disposed on a side of an area in which the first display driver integrated circuit 131 and the second display driver integrated circuit 132 are located.

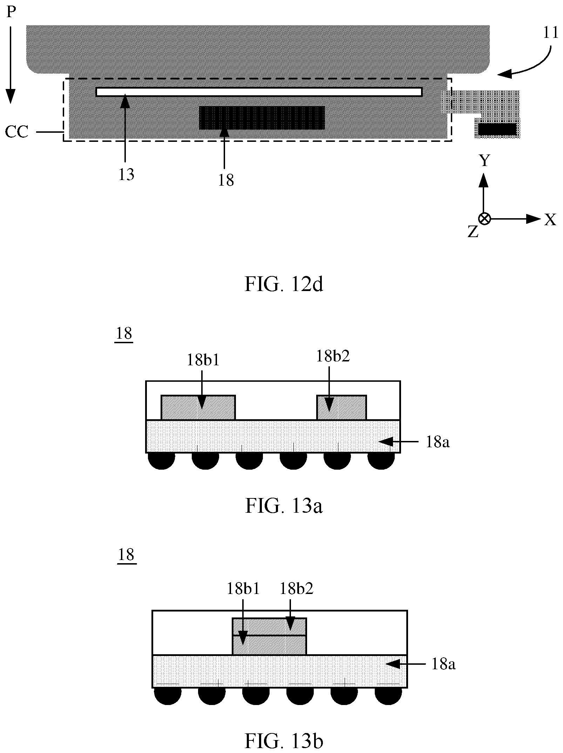

FIG. 12d shows still another manner of setting relative positions of the packaging structure 18 and the display driver integrated circuit 13. Different from FIG. 12a, FIG. 12b, and

FIG. 12c, in this implementation, there is one display driver integrated circuit 13. For example, the display assembly may be used in a bar-type electronic device (for example, the bar-type mobile phone in FIG. 3b), and the display driver integrated circuit 13 drives and controls the flexible display panel 11 that continuously covers the housing 100d.

Still refer to FIG. 12d. The display driver integrated circuit 13 and the packaging structure 18 are arranged in a direction parallel to an extension direction (for example, a P direction in the figure) of the lower frame area CC.

This application provides at least two manners of disposing an electronic component in the packaging structure 18.

FIG. 13a shows one of the manners of disposing a plurality of electronic components. As shown in FIG. 13a, each of the plurality of electronic components is disposed on a substrate 18a by using an electrical connection structure. For example, FIG. 13a shows an example in which the electronic components include a first electronic component 18b1 and a second electronic component 18b2, both the first electronic component 18b 1 and the second electronic component 18b2 are disposed on the substrate 18a by using the electrical connection structure, and the plurality of electronic components are disposed on the substrate 18a in a two-dimensional integration manner.

FIG. 13b shows another manner of disposing a plurality of electronic components. The plurality of electronic components are stacked on the substrate 18a in a direction perpendicular to the substrate 18a. For example, the first electronic component 18b1 and the second electronic component 18b2 shown in FIG. 13b are stacked on the substrate 18a, and the plurality of electronic components are disposed on the substrate 18a in a three-dimensional integration manner.

The substrate 18a in the packaging structure 18 in embodiments of this application has a plurality of implementable structures.

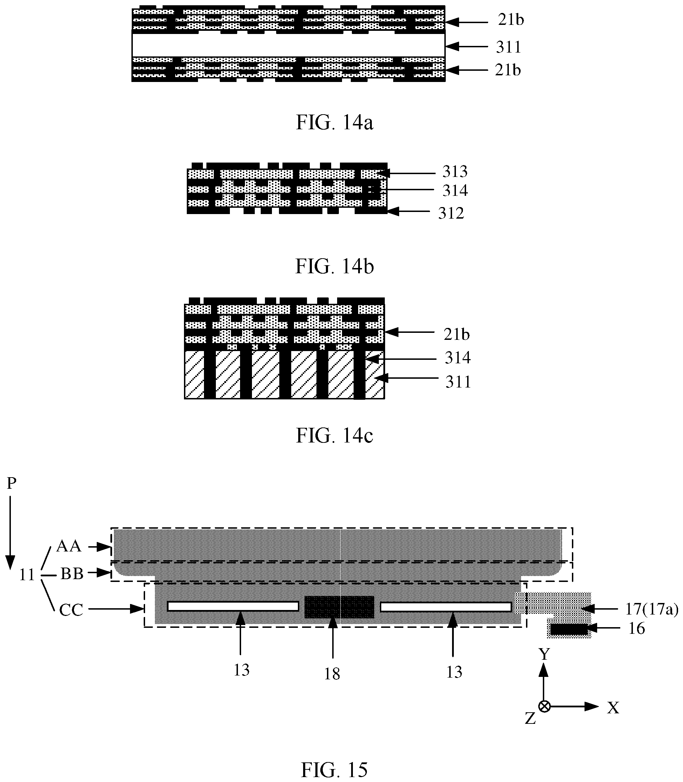

For example, the substrate 18a may be a packaging substrate (substrate) shown in FIG. 14a. The packaging substrate includes a base 311 and redistribution structures 21b located on an upper surface and a lower surface of the base 311.

For another example, the substrate 18a may be a redistribution layer (redistribution layer, RDL) that is obtained by using a re-routing process and that is shown in FIG. 14b. The RDL includes a plurality of layers of metal wires 312 and a plurality of dielectric layers 313, and every two adjacent layers of metal wires 312 are spaced by using one dielectric layer 313. To enable the metal wires 312 at different layers to be electrically connected, a conductive channel 314 may be made in the dielectric layer 313, so that the metal wires 312 at different layers are electrically connected through the conductive channel 314. When the RDL is used as a substrate, flexibility of the substrate can be further improved, and a warping degree of a package body can be suppressed.

For another example, the substrate 18a may be an interposer (Interposer) shown in FIG. 14c. The interposer includes a base 311, a redistribution layer RDL integrated on the base 311, and a conductive channel 314 that passes through the base 311. The conductive channel 314 is electrically connected to a metal wire in the redistribution layer RDL 21b.

FIG. 15 is diagram of another structure of a display assembly according to an embodiment of this application. The display assembly not only includes the flexible display panel 11, the display driver integrated circuit 13, and the packaging structure 18, but also includes the circuit board 17. The circuit board 17 may be a flexible printed circuit board (flexible printed circuit board, FPC) electrically connected to a main circuit board of an electronic device.

The circuit board 17 in the display assembly in this embodiment of this application is not only small in size, but also disposed at different positions. In this embodiment of this application, as shown in FIG. 15, the circuit board 17 extends in a direction perpendicular to an extension direction (for example, a direction P in the figure) of the lower frame area CC, and the circuit board 17 is electrically connected to the lower frame area CC and the main circuit board. For example, the circuit board 17 may be electrically connected to the main circuit board through a bonding structure 16. However, in the conventional technology shown in FIG. 2, the flexible printed circuit board 12 extends in a direction parallel to the extension direction (for example, a direction P in the figure) of the lower frame area CC.

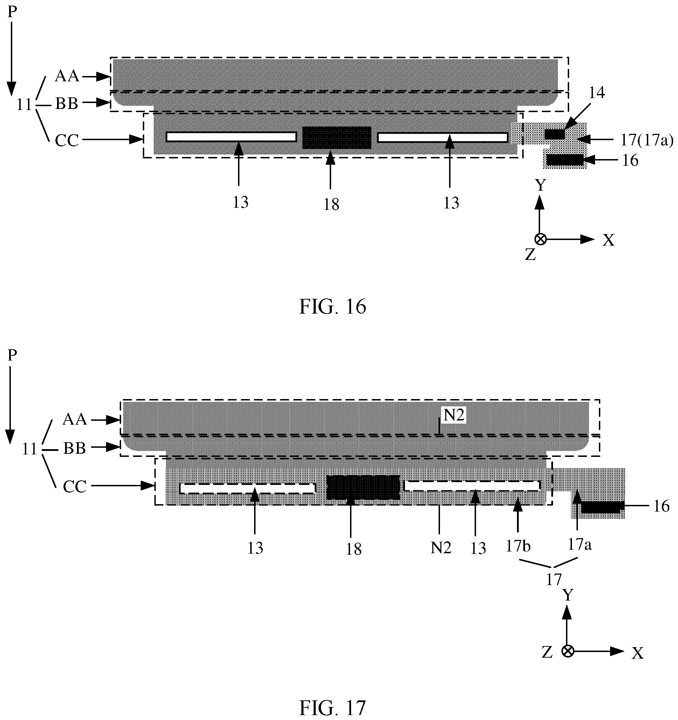

The circuit board 17 with a small size provided in this embodiment of this application does not occupy large space in an X direction. For example, as shown in FIG. 16, the circuit board 17 extending to a side of the flexible display panel 11 may be referred to as a first part 17a. In an assembly process, the first part 17a used as an electrical connection structure of the main circuit board may be bent in a direction perpendicular to the X direction, to be electrically connected to the main circuit board. This further reduces space occupied by the circuit board 17 in the X direction.

In some implementations, all electronic components that are electrically connected to the display driver integrated circuit 13 and the flexible display panel 11 may be integrated into the packaging structure 18 by using a packaging technology, or some electronic components may be integrated into the packaging structure 18. For example, in FIG. 15, all electronic components electrically connected to the display driver integrated circuit 13 and the flexible display panel 11 are integrated into the packaging structure 18 by using a packaging technology, so that the circuit board 17 is used as an electrical connection structure connected to the main circuit board. For another example, as shown in FIG. 16, some electronic components may be integrated into the packaging structure 18, and some electronic components 14 are disposed on the first part 17a.

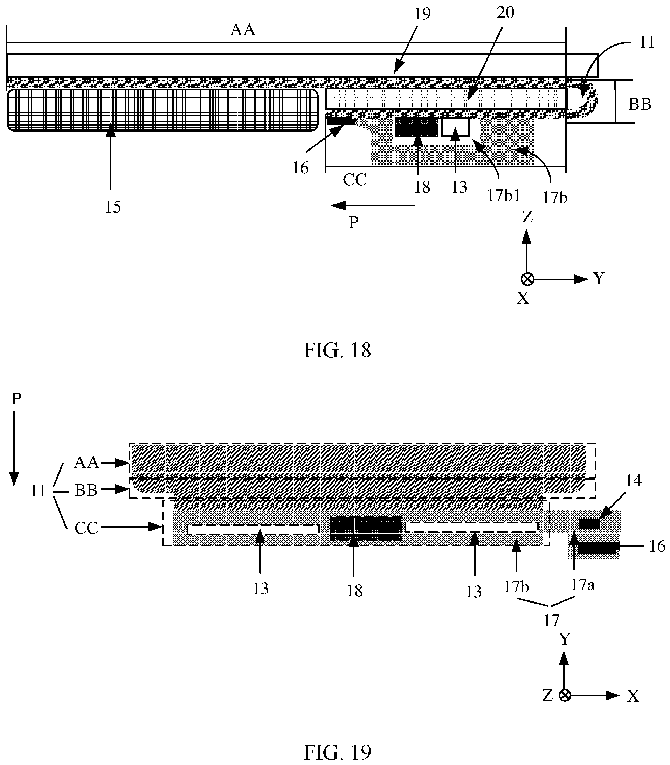

FIG. 17 is diagram of still another structure of a display assembly according to an embodiment of this application. FIG. 18 is a sectional view obtained after cutting along N2-N2 in FIG. 17. With reference to FIG. 17 and FIG. 18, in comparison with FIG. 15 and FIG. 16, the display assembly not only includes the flexible display panel 11, the display driver integrated circuit 13, the packaging structure 18, and the first part 17a. Another part of the circuit board 17 covers the lower frame area CC, to form a second part 17b. The second part 17b and the first part 17a are an integrated structure.

As shown in FIG. 18, the second part 17b is provided with an accommodating cavity 17b1, and both the display driver integrated circuit 13 and the packaging structure 18 are disposed in the accommodating cavity 17b1. In this way, the display driver integrated circuit 13 and the packaging structure 18 that are shown in FIG. 17 are disposed between the second part 17b and the lower frame area CC, and are shown by using dashed lines.

In a connection process, as shown in FIG. 18, the second part 17b may be electrically connected to the lower frame area CC through a bonding structure 16. In this way, the second part 17b may be compatible with an existing connection process between the circuit board 17 and the flexible display panel 11, and no additional preparation process means is added.

In some implementations, all electronic components electrically connected to the display driver integrated circuit 13 and the flexible display panel 11 may be integrated into the packaging structure 18 by using a packaging technology, or some electronic components may be integrated into the packaging structure 18. For example, in FIG. 17, all electronic components electrically connected to the display driver integrated circuit 13 and the flexible display panel 11 are integrated into the packaging structure 18 by using a packaging technology, so that the circuit board 17 is used as an electrical connection structure connected to the main circuit board. For another example, as shown in FIG. 19, some electronic components may be integrated into the packaging structure 18, and some electronic components 14 are disposed on the first part 17a.

Refer to both FIG. 17 and FIG. 19. In this embodiment of this application, some electronic components are integrated into the packaging structure 18 by using a packaging technology. Therefore, a routing structure of the circuit board 17 can be simplified, for example, a quantity of conductive layers of the second part 17b can be reduced. For example, original at least four conductive layers may be reduced to one or two conductive layers.

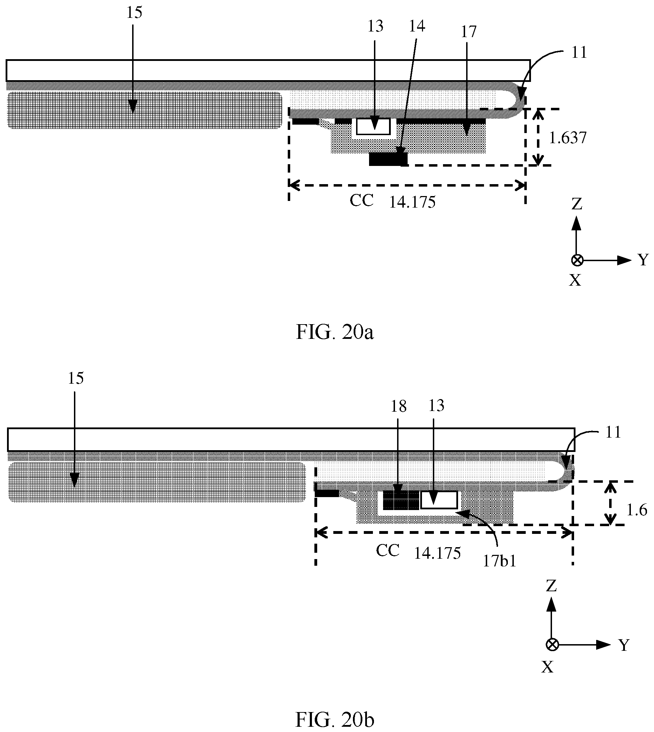

FIG. 20a is a diagram of a structure of a display assembly. In the display assembly, the circuit board 17 is also disposed in the lower frame area CC of the flexible display panel 11. However, the electronic component 14 is integrated on a surface that is of the circuit board 17 and that is far away from the lower frame area CC, and is not arranged by using a system in package technology. In this way, a distance between a surface that is of the electronic component 14 and that is far away from the circuit board 17 and a surface of the lower frame area CC is about 1.637 mm shown in FIG. 20a.

However, in a diagram of a structure of a display assembly provided in this embodiment of this application shown in FIG. 20b, because the packaging structure 18 integrated with an electronic component is mounted in the accommodating cavity 17b1 of the circuit board, a distance between the surface that is of the circuit board 17 and that is far away from the lower frame area CC and the lower frame area CC is 1.6 mm. In other words, 1.6 mm in this application is compared with 1.637 mm in FIG. 20a. A position of the electronic component changes because a quantity of layers of the routing structure of the circuit board 17 is reduced, and large space is not occupied in a Z direction, so that a size of the electronic device in the Z direction is not greatly increased.

In this embodiment of this application, after the packaging structure 18 having the electronic component is disposed in the lower frame area CC of the flexible display panel 11, a routing structure needs to be formed on the lower frame area CC, to electrically connect the packaging structure 18 and the display driver integrated circuit 13, or electrically connect the packaging structure 18 and the display area AA.

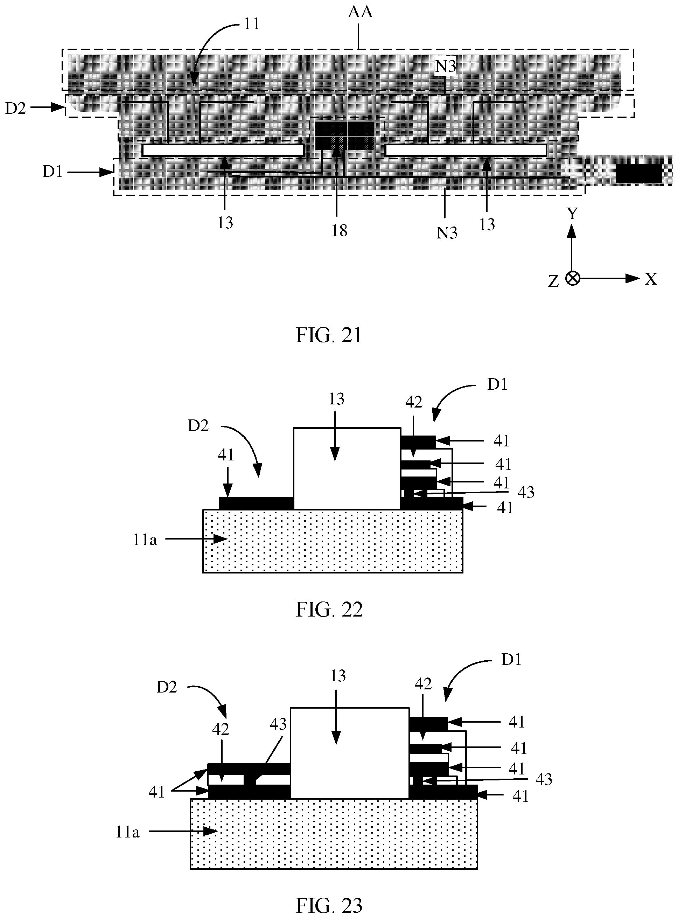

FIG. 21 is a diagram of a structure of a display assembly according to an embodiment of this application. The display assembly includes a routing structure configured to electrically connect the packaging structure 18 and another electronic component (for example, a display driver integrated circuit or a display area). FIG. 21 shows not only a first routing structure D1 in which the packaging structure 18 is electrically connected and another electronic component, but also a second routing structure D2 in which the display driver integrated circuit 13 is electrically connected to the display area, and black lines in the first routing structure D1 and the second routing structure D2 in FIG. 21 are metal wires drawn as examples.

FIG. 22 is a sectional view of FIG. 21 obtained after cutting along N3-N3. With reference to FIG. 21 and FIG. 22, the first routing structure D1 and the second routing structure D2 have different implementable structures. The first routing structure D1 includes a plurality of conductive layers 41 stacked on the base 11a. The plurality of conductive layers 41 are stacked in a direction perpendicular to the base 11a, and every two adjacent conductive layers 41 are isolated by a dielectric layer 42. In addition, the first routing structure D1 further includes a conductive channel 43. The conductive channel 43 passes through the dielectric layer 42 to electrically connect different conductive layers 41. For example, FIG. 22 shows the first routing structure D1 including four conductive layers 41. The four conductive layers may be a source and drain wire, a gate wire, a TMA wire, and a TMB wire respectively.

Refer to FIG. 21 and FIG. 22 again. The second routing structure D2 includes one conductive layer 41.

For ease of clear understanding, in the first routing structure D1, the conductive layer may be referred to as a first conductive layer, the dielectric layer may be referred to as a first dielectric layer, and the conductive channel may be referred to as a first conductive channel. In the second routing structure D2, the conductive layer is referred to as a second conductive layer, the dielectric layer is referred to as a second dielectric layer, and the conductive channel is referred to as a second conductive channel. However, in an actual process structure, the first conductive layer and the second conductive layer may be made of a same material, the first dielectric layer and the second dielectric layer may be made of a same material, and the first conductive channel and the second conductive channel may be made of a same material.

FIG. 23 shows other implementable structures of the first routing structure D1 and the second routing structure D2 according to an embodiment of this application. In this embodiment, the first routing structure D1 has a same structure as the first routing structure D1 in FIG. 22, and also includes four conductive layers 41. However, the second routing structure D2 includes two conductive layers 41. The two conductive layers 41 are isolated by the dielectric layer 42, and the two conductive layers 41 are electrically connected through the conductive channel 43 of the dielectric layer 42, to form a routing layer structure having an electrical connection function. For example, the two conductive layers may be respectively a gate wire and a source and drain wire.

In conclusion, the first routing structure D1 provided in this embodiment of this application is a routing structure with at least three conductive layers, and the second routing structure D2 is a routing structure with a single conductive layer or two conductive layers.

When the first routing structure D 1 and the second routing structure D2 are formed on the flexible display panel 11, the first routing structure D1 and the second routing structure D2 cannot affect each other, that is, the first routing structure D1 cannot affect an electrical connection function of the second routing structure D2. Similarly, the second routing structure D2 cannot affect an electrical connection function of the first routing structure D1. Therefore, in an implementable process structure, an area in which the first routing structure D1 is located does not overlap an area in which the second routing structure D2 is located as much as possible. For example, as shown in FIG. 21, FIG. 22, and FIG. 23, the area in which the second routing structure D2 is located on a side that is of the display driver integrated circuit 13 and that is close to a bent area, and the area in which the first routing structure D1 is located on a side that is of the display driver integrated circuit 13 and that is far away from the bent area. That is, the second routing structure D2 is disposed close to the bent area compared with the first routing structure D 1.

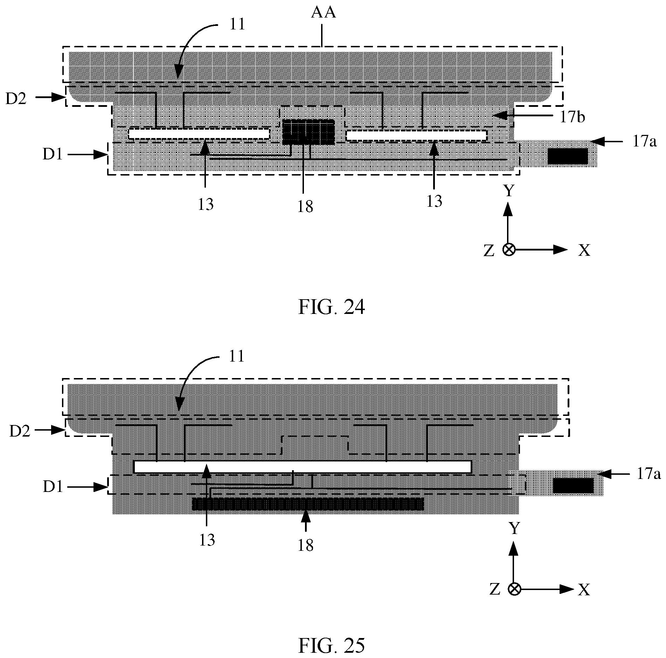

FIG. 24 is a diagram of still another structure of a display assembly according to an embodiment of this application. Similar to the display assembly shown in FIG. 21, FIG. 24 shows not only the first routing structure D 1 in which the packaging structure 18 is electrically connected to another electronic component, but also the second routing structure D2 in which the display driver integrated circuit 13 is electrically connected to a display area. A difference lies in that: in FIG. 21, the circuit board 17 includes the first part 17a located on a side of the lower frame area CC, while in FIG. 24, the circuit board 17 not only includes the first part 17a, but also includes a second part 17b adjacent to the first part 17a, and the second part 17b is electrically connected to the lower frame area through a bonding structure.

A layout manner of the first routing structure D1 and the second routing structure D2 in FIG. 24 may be a layout manner shown in FIG. 21, and details are not described herein again.

In some implementation structures, the packaging structure 18 in FIG. 24 may be a touch chip packaging structure. In addition, if a wire outside the display driver integrated circuit 13 needs to be interconnected to a middle area of the packaging structure 18, considering that routing of a touch chip TPIC has a strict impedance requirement, a multi-layer wiring area that directly passes through the lower frame area has a risk that impedance increases beyond a limit. In this case, the routing of the touch chip TPIC may be centralized to the area of the packaging structure 18 through routing in the second part 17b, and then the wire is interconnected through bonding between the second part 17b and the lower frame area, to implement low impedance connection between an external touch chip TPIC wire and an internal system in package SIP pin.

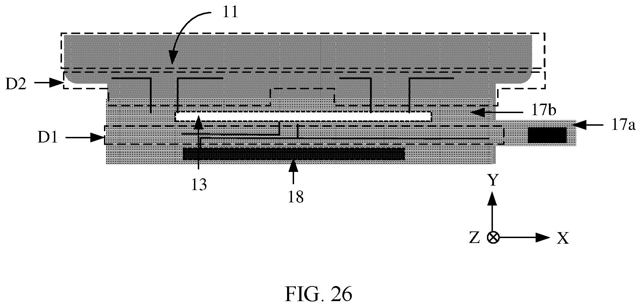

FIG. 25 and FIG. 26 are diagrams of structures of two different display assemblies according to an embodiment of this application. A difference between the display assemblies shown in FIG. 25 and FIG. 26 and the display assemblies shown in FIG. 21 and FIG. 24 lies in that: in FIG. 25 and FIG. 26, one display driver integrated circuit 13 is included, and the display driver integrated circuit 13 and the packaging structure 18 are arranged in a direction parallel to an extension direction of the lower frame area CC.

In FIG. 25 and FIG. 26, the first routing structure D1 is formed between the display driver integrated circuit 13 and the packaging structure 18, and the second routing structure D2 is formed on a side that is of the display driver integrated circuit 13 and that is far away from the packaging structure 18.

A layout manner of the first routing structure D1 and the second routing structure D2 in FIG. 25 and FIG. 26 may also be the layout manner shown in FIG. 21, and details are not described herein again.

An embodiment of this application further provides a display assembly preparation method. The preparation method includes:
disposing, on a lower frame area of a flexible display panel, a chip package body electrically connected to a display area, where for example, the chip package body may be a display driver integrated circuit; and
disposing a packaging structure on the lower frame area. The packaging structure includes a substrate disposed in the lower frame area, and a first electronic component and a second electronic component disposed on the substrate, and the first electronic component and the second electronic component are electrically connected to the display area through a first routing structure formed in the lower frame area. The flexible display panel includes the display area, a bent area located at an outer edge of the display area, and the lower frame area adjacent to the bent area. The bent area is used for bending the lower frame area to the back of the display area.

In the preparation method, not only the chip package body for controlling the display area is disposed in the lower frame area of the flexible display panel, but also some other electronic components electrically connected to the display area are integrated into the packaging structure through system in package, and the packaging structure is also disposed in the lower frame area. The display assembly obtained through production in this way can reduce a size of a circuit board (for example, a flexible printed circuit board) electrically connected to a main circuit board. In this way, more disposing space can be reserved for another structure.

In addition, after the packaging structure and the chip package body are disposed in the lower frame area, the preparation method further includes:
disposing a circuit board, where the circuit board extends in a direction perpendicular to an extension direction of the lower frame area.

In this embodiment of this application, the circuit board electrically connected to the main circuit board may extend in the direction perpendicular to the extension direction of the lower frame area, and be stacked on the lower frame area.

In some implementations, before the display driver integrated circuit and the packaging structure are integrated into the flexible display panel, a plurality of conductive layers (at least three layers) are formed in the display area, the bent area, and the lower frame area of the flexible display panel.

Therefore, before the packaging structure and the display driver integrated circuit are disposed in the lower frame area, the preparation method further includes: removing a conductive layer and a dielectric layer that are in the lower frame area and that are configured to form a second routing structure, so that the formed second routing structure that is electrically connected to the chip package body and the display area is a single conductive layer or two conductive layers, and retaining a quantity of conductive layers and dielectric layers that are in the lower frame area and that are configured to form the first routing structure to be the same as a quantity of conductive layers and dielectric layers in the display area.

In a process that can be implemented, processing needs to be performed on an area that is on the lower frame area and that is used to form the second routing structure and the bent area, to form a single conductive layer or two conductive layers. Other areas may not be processed. In this way, the preparation process can also be simplified.

In some technical manners, an electronic component may also be disposed on a first part that is of the circuit board and that is located on a side of the lower frame area, so that the electronic component is electrically connected to the display area.

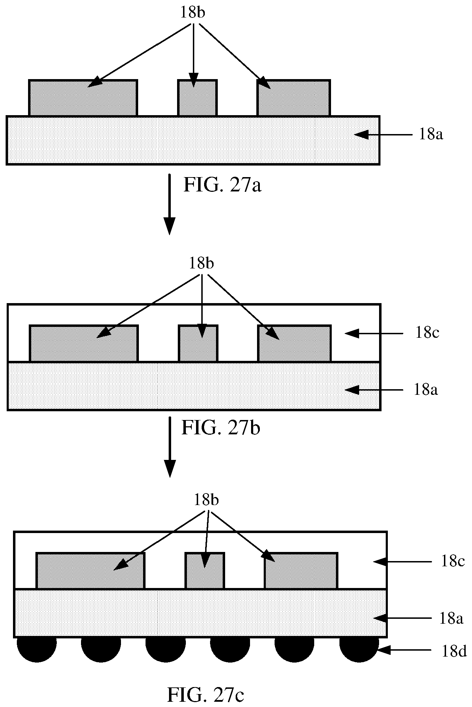

FIG. 27a to FIG. 27c show an implementable preparation method of the packaging structure 18.

With reference to FIG. 27a, a plurality of electronic components 18b are disposed on the substrate 18a. For example, FIG. 27a shows an example in which three electronic components 18b are disposed on the substrate 18a.

A structure that can be selected for the substrate 18a has been described in detail above, and details are not described herein again.

In addition, FIG. 27a shows that a plurality of electronic components are disposed on the substrate 18a in a two-dimensional integration manner. In some other processes, one part of the plurality of electronic components may be disposed on the substrate 18a in a three-dimensional integration manner, and the other part of the electronic components may be disposed on the substrate 18a in a two-dimensional integration manner.

With reference to FIG. 27b, the packaging layer 18c is disposed on the substrate 18a on which the plurality of electronic components 18b are formed, so that the packaging layer 18c wraps the plurality of electronic components 18b. This implements galvanic isolation between the electronic components 18b and the outside. In some implementations, a plastic packaging layer may be used as the packaging layer 18c.

With reference to FIG. 27c, an electrical connection structure 18d is formed on a side surface that is of the substrate 18a and that is away from the plurality of electronic components 18b. For example, the electrical connection structure 18d may include a plurality of solder balls, for example, a ball grid array (ball grid array, BGA), or include a plurality of metal columns. In this way, a system in package structure that integrated with the plurality of electronic components is obtained.

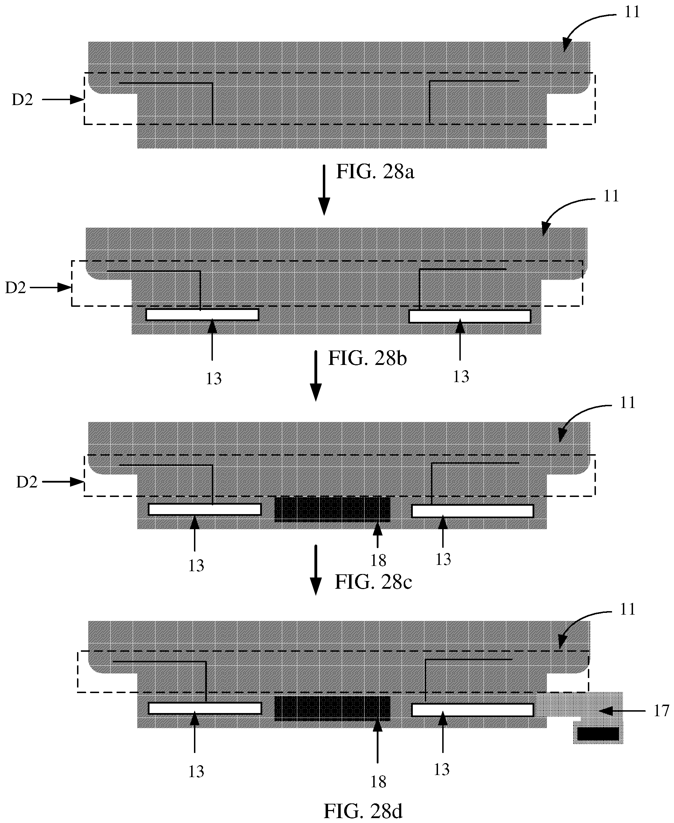

FIG. 28a to FIG. 28d show an implementable preparation method in which the packaging structure 18 and the display driver integrated circuit 13 are disposed on the flexible display panel 11.

With reference to FIG. 28a, conductive layer removal processing is performed in an area that is of the flexible display panel 11 and that is used to form a bent area and that is used to form a second routing structure D2 (a routing part that is used to electrically connect the display driver integrated circuit 13 and a display area), so that routing in these areas is routing with a single conductive layer or routing with two conductive layers.

Routing in another area is not processed, that is, a routing structure that is the same as that in the display area of the flexible display panel 11 is retained.

With reference to FIG. 28b, the display driver integrated circuit 13 is disposed in a lower frame area of the flexible display panel 11.

With reference to FIG. 28c, the packaging structure 18 obtained in FIG. 27a to FIG. 27c is disposed in the lower frame area of the flexible display panel 11.

With reference to FIG. 28d, the circuit board 17 is further disposed, and the circuit board 17 is electrically connected to the flexible display panel 11.

By using the process shown in FIG. 28a to FIG. 28d, a display assembly including the display driver integrated circuit 13, the packaging structure 18, and the circuit board 17 is obtained.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display assembly, comprising:
a flexible display panel, comprising a display area, a bent area located at an outer edge of the display area, and a lower frame area adjacent to the bent area, wherein the lower frame area is located on the back of the display area;
a chip package body, disposed in the lower frame area and electrically connected to the display area; and
a packaging structure, comprising a substrate, and a first electronic component and a second electronic component that are disposed on the substrate, wherein the substrate is disposed in the lower frame area, wherein
the lower frame area comprises a first routing structure, and the first electronic component and the second electronic component are electrically connected to the chip package body through the first routing structure.

2. The display assembly according to claim 1, wherein the display assembly further comprises a circuit board; and
an extension direction of the circuit board is perpendicular to an extension direction of the lower frame area, and the circuit board is configured to electrically connect the lower frame area and a main circuit board.

3. The display assembly according to claim 2, wherein a first part of the circuit board is located on a side of the lower frame area, and the first part is configured to electrically connect to the main circuit board.

4. The display assembly according to claim 3, wherein a second part of the circuit board covers the lower frame area, and the second part is electrically connected to the lower frame area; and
an accommodating cavity is provided on the second part, and both the chip package body and the packaging structure are disposed in the accommodating cavity.

5. The display assembly according to claim 3 or 4, wherein the display assembly further comprises a third electronic component; and
the third electronic component is disposed on the first part, and the third electronic component is electrically connected to the display area, or the third electronic component is electrically connected to the packaging structure.

6. The display assembly according to any one of claims 1 to 5, wherein the first electronic component or the second electronic component comprises at least one of a touch chip and a passive component.

7. The display assembly according to any one of claims 1 to 6, wherein the chip package body is a display driver integrated circuit that drives display in the display area.

8. The display assembly according to any one of claims 1 to 7, wherein the lower frame area comprises a base, and the first routing structure is formed on the base; and
the first routing structure comprises: at least three first conductive layers, wherein the at least three first conductive layers are stacked in a direction perpendicular to the base;
a first dielectric layer, wherein the first dielectric layer is disposed between every two adjacent first conductive layers; and
a first conductive channel, wherein the first conductive channel passes through the first dielectric layer, to electrically connect different first conductive layers.

9. The display assembly according to claim 8, wherein the lower frame area further comprises a second routing structure; and
the chip package body is electrically connected to the display area through the second routing structure.

10. The display assembly according to claim 9, wherein
the second routing structure comprises one second conductive layer; or
the second routing structure comprises:
two second conductive layers, wherein the two second conductive layers are stacked in the direction perpendicular to the base;
one second dielectric layer, wherein the second dielectric layer is disposed between the two second conductive layers; and
a second conductive channel, wherein the second conductive channel passes through the second dielectric layer, to electrically connect the two second conductive layers.

11. The display assembly according to claim 9 or 10, wherein the second routing structure is arranged closer to the bent area than the first routing structure.

12. The display assembly according to any one of claims 1 to 11, wherein an arrangement direction of the chip package body and the packaging structure is perpendicular to or parallel to the extension direction of the lower frame area.

13. The display assembly according to claim 12, wherein the chip package body comprises a first display driver integrated circuit and a second display driver integrated circuit, an arrangement direction of the first display driver integrated circuit and the second display driver integrated circuit is perpendicular to the extension direction of the lower frame area, and the packaging structure is located between the first display driver integrated circuit and the second display driver integrated circuit.

14. The display assembly according to any one of claims 1 to 13, wherein the chip package body and the packaging structure are located on a side surface that is of the lower frame area and that is away from the display area.

15. The display assembly according to any one of claims 1 to 14, wherein the first electronic component and the second electronic component are separately disposed on a same surface of the substrate through an electrical connection structure; or
the first electronic component and the second electronic component are stacked on the substrate in a direction perpendicular to the substrate.

16. An electronic device, comprising:
the display assembly according to any one of claims 1 to 15; and
a main circuit board, wherein
the display assembly is electrically connected to the main circuit board.

17. The electronic device according to claim 16, wherein
placement space is formed on a side that is of the lower frame area and that is far away from the bent area; and
the electronic device further comprises a battery, and the battery is disposed in the placement space.

18. A display assembly preparation method, comprising:
disposing, on a lower frame area of a flexible display panel, a chip package body electrically connected to a display area; and
disposing a packaging structure on the lower frame area, wherein the packaging structure comprises a substrate disposed in the lower frame area, and a first electronic component and a second electronic component disposed on the substrate, and the first electronic component and the second electronic component are electrically connected to the chip package body through a first routing structure formed on the lower frame area, wherein
the flexible display panel comprises the display area, a bent area located at an outer edge of the display area, and the lower frame area adjacent to the bent area, wherein the lower frame area is located on the back of the display area.

19. The display assembly preparation method according to claim 18, wherein before the packaging structure and the chip package body are disposed in the lower frame area, the preparation method further comprises:
removing a conductive layer and a dielectric layer that are in the lower frame area and that are configured to form a second routing structure, so that the formed second routing structure that is electrically connected to the chip package body and the display area is a single conductive layer or two conductive layers, and retaining a quantity of conductive layers and dielectric layers that are in the lower frame area and that are configured to form the first routing structure to be the same as a quantity of conductive layers and dielectric layers in the display area.

20. The display assembly preparation method according to claim 18 or 19, wherein after the packaging structure and the chip package body are disposed in the lower frame area, the preparation method further comprises:
disposing a circuit board, wherein the circuit board extends in a direction perpendicular to an extension direction of the lower frame area.

21. The display assembly preparation method according to claim 20, wherein before the disposing a circuit board, the preparation method further comprises:
disposing a third electronic component on a part that is of the circuit board and that is located on a side of the lower frame area, so that the third electronic component is electrically connected to the display area, or the third electronic component is electrically connected to the packaging structure.
